Europäisches Patentamt

European Patent Office

Office européen des brevets

(11) Veröffentlichungsnummer: **0 456 870 A1**

# (12) EUROPÄISCHE PATENTANMELDUNG

(21) Anmeldenummer: 90109413.6

(22) Anmeldetag: 18.05.90

(51) Int. Cl.5: **H05K 3/26, B08B 3/02**

(43) Veröffentlichungstag der Anmeldung:
**21.11.91 Patentblatt 91/47**

(84) Benannte Vertragsstaaten:
**BE CH DE DK ES FR GB IT LI LU NL SE**

(71) Anmelder: **SCHERING AKTIENGESELLSCHAFT**
**Berlin und Bergkamen**
**Müllerstrasse 170/178 Postfach 65 03 11**

**W-1000 Berlin 65(DE)**

(72) Erfinder: **Kallweit, Manfred**
**Ragniter Allee 3a**
**W-1000 Berlin 19(DE)**
Erfinder: **Bläsing, Horst**
**Strünckweg 1**
**W-1000 Berlin 13(DE)**

(54) **Anordnung zur chemischen Behandlung und/oder Reinigung von Gut, insbesondere von mit Bohrungen versehenen Leiterplatten, sowie dazugehöriges Verfahren (Fall B).**

(57) Die Erfindung geht aus von einer Anordnung zur Behandlung und/oder Reinigung von Gut, insbesondere von mit Bohrungen versehenen Leiterplatten mit Hilfe einer im Schwall herangeführten Flüssigkeit. Um die Wirkung des Schwallstromes zu verstärken bzw. zu ergänzen ist vorgesehen, daß auf einer Seite des zu reinigenden oder zu behandelnden Gutes (5) eine Schwallstrecke (8) und auf der anderen Seite des Gutes eine Saugstrecke (10) vorgesehen ist. Ferner betrifft die Erfindung ein Verfahren zur Einstellung des Verhältnisses der über die jeweilige Schwallstrecke zugeführten zu der über die jeweilige Saugstrecke abgeführten Flüssigkeitsmenge.

Fig. 4

Die Erfindung betrifft eine Anordnung gemäß dem Oberbegriff des Anspruches 1. Eine derartige Reinigung oder Behandlung mittels eines Schwallstromes einer entsprechenden Flüssigkeit ist DE-PS 30 11 061 und ferner DE-OS 35 28 575 zu entnehmen. Dabei beschreibt DE-PS 30 11 061 die Zuführung eines Schwallstromes an das Gut von unten, während DE-OS 35 28 575 eine Behandlung entweder nur mit unteren Schwalldüsen, oder aber im Fall von Reinigungsprozessen mit Ultraschall und elektrisch-chemischen Prozessen zwei Schwalldüsen vorsieht, die jeweils versetzt auf der Ober- und Unterseite der Leiterplatte positioniert sind. Die in den beiden zitierten Vorveröffentlichungen beschriebenen Verfahren und Einrichtungen haben sich vom Prinzip her bewährt, werden aber nicht allen Anforderungen in der Praxis gerecht.

Die Aufgabe der Erfindung besteht darin, eine Anordnung gemäß dem Oberbegriff des Anspruches 1 so auszugestalten, daß die Wirkung des Schwallstromes verstärkt, bzw. ergänzt wird.

Die Lösung dieser Aufgabe wird, ausgehend vom Oberbegriff des Anspruches 1, zunächst in den Merkmalen des Kennzeichens des Anspruches 1 gesehen. Die Saugstrecke verstärkt die Wirkung der Schwallstrecke, da die Kraft der Absaugung in der gleichen Richtung wirkt wie der Schwallstrom. Es ergibt sich also eine Kombinationswirkung.

In der Ausführungsform gemäß Anspruch 2 wirkt die Saugkraft unmittelbar auf den Schwallstrom, der von der Schwallstrecke her durch die Bohrungen des zu behandelnden oder zu reinigenden Gutes hindurchtritt. In der Ausführung gemäß Anspruch 3 wirkt die Saugkraft der Saugstrecke mit einer gewissen zeitlichen Verzögerung und bewirkt, daß etwa noch in den Bohrungen des zu behandelnden oder zu reinigenden Gutes hängengebliebene Flüssigkeitsreste abgesaugt werden. Diese Anordnung empfiehlt sich besonders dann, wenn die Flüssigkeit eine Behandlungsflüssigkeit (z.B. eine Säure) ist, während die zuvor erläuterte Variante der Erfindung gemäß Anspruch 2 der direkten Beschleunigung oder Verstärkung des Schwallstromes dient.

Eine in ihrer Zusammenwirkung besonders vorteilhafte Ausführungsform ist Gegenstand des Anspruches 6. Die eine Gruppe transportiert die Flüssigkeit von oben nach unten und die andere Gruppe von unten nach oben durch die Bohrungen des zu reinigenden oder behandelnden Gutes. Hiermit wird eine besonders intensive Reinigung und Behandlung erreicht.

Unter einem Schwall wird, wie auch die eingangs zitierte Literatur ausweist, eine kontinuierlich fließende Flüssigkeitssäule oder ein Flüssigkeitsstrang verstanden, der mit entsprechender kinetischer Energie aus der Schwallstrecke austritt und in dieser Schwallform an das zu behandelnde oder zu reinigende Gut gelangt; während im Gegensatz hierzu vorbekannte Spritz- oder Sprühvorrichtungen eine versprühte oder vernebelte Behandlungsflüssigkeit, die also stark mit Luft durchsetzt ist, gegen das zu behandelnde Gut spritzen. Demgegenüber ist der Hauptvorteil eines solchen Schwallstromes, daß er vorhandene Bohrungen intensiv mit der Flüssigkeit durchsetzt und sie somit wesentlich vollständiger reinigt als dies mit einem Versprühen oder Verspritzen einer Flüssigkeit möglich wäre.

Die Merkmale des Anspruches 7 schaffen zusätzlich zu dem Schwallstrom einen Aufstau der Reinigungs- oder Behandlungsflüssigkeit. Hiermit wirkt neben der kinetischen Energie des Schwallstromes auch die Schwerkraft dieses Flüssigkeitsstaues auf das Gut. Beides ergänzt sich. Von Vorteil ist bei dieser Kombination eines solchen Staus mit einer oberhalb des Behandlungsgutes angeordneten Schwallstrecke, daß die Schwallstrecke im Staubereich einen gewissen Raum einnimmt, so daß weniger an Flüssigkeitsmenge gestaut werden muß um eine gewisse Höhe des Flüssigkeitsspiegels des Staues zu erreichen. Hierdurch wird die benötigte Pumpenleistung geringer.

Mit den vorstehend erläuterten Merkmalen des Anspruches 7 wird der Effekt der Reinigung des zu behandelnden Gutes und insbesondere der Reinigung von Bohrungen verstärkt. Dabei ist insbesondere an Leiterplatten für die Elektronik gedacht, die mit relativ dünnen Bohrungen versehen sind. die einer besonders intensiven Reinigung und Spülung bedürfen. Mit dem Aufstau der Flüssigkeit innerhalb der Schwallstrecke wird ferner ein gewisses Reservoir an Flüssigkeit geschaffen, das dann von Vorteil ist, wenn der Zustrom an Flüssigkeit aus irgendeinem Grund kurzzeitig verringert oder sogar unterbrochen werden sollte. Außerdem wird durch diesen Aufstau die Strecke, über welche die Behandlungsflüssigkeit auf das Gut einwirken kann, verlängert. Dies ist vorteilhaft, auch wenn die intensivste Einwirkung erst im Schwallraum eintritt.

Die Merkmale des Anspruches 8 stellen eine konstruktiv einfache und im Betrieb vorteilhafte Ausgestaltung der Staumittel gemäß Anspruch 7 dar. Die Quetschwalzen drehen sich mit dem an ihnen anliegenden und vorbeigeführten Behandlungsgut, so daß eine schädliche Reibung zwischen Staumittel und Behandlungsgut vermieden ist.

Die Merkmale des Anspruches 9 stellen eine weitere vorteilhafte Ausführungsform dar, die sich besonders zum Reinigen von Sacklöchern oder -bohrungen in dem plattenförmigen Gut eignet.

Die Merkmale des Anspruches 11 bewirken, daß über die gesamte Breite des zu behandelnden Gutes eine gleichmäßige Verteilung und auch in etwa gleichmäßiger Ausströmquerschnitt des Flüssigkeitsschwalles gegeben ist. Eine solche Anordnung ist zwar für sich aus DE-OS 35 28 575 bekannt, jedoch nicht in Verbindung mit einer Anordnung gemäß einem oder mehreren der vorstehend erläuterten Ansprüche.

Die Merkmale des Ansprpches 12 betreffen eine vorteilhafte Weiterbildung der Merkmale des Anspruches 11.

Anspruch 14 betrifft eine Verfahrensweise, um mit einer solchen Anordnung nach einem oder mehreren der vorhergehenden Ansprüche zu arbeiten.

Es können die verschiedenen Ausgestaltungsmöglichkeiten der Erfindung gemäß den vorhergehenden Ansprüchen miteinander kombiniert werden.

Weitere Vorteile und Merkmale der Erfindung sind den weiteren Unteransprüchen, sowie der nachstehenden Beschreibung und der zugehörigen, im wesentlichen schematischen Zeichnung zu entnehmen. In der Zeichnung zeigt:

Fig. 1: eine Draufsicht auf eine Anordnung nach der Erfindung, wobei in der in der Zeichnung linken Hälfte die Ausführungsform nach Fig. 2 und in der in der Zeichnung rechten Hälfte die Ausführungsform nach Fig. 3 schematisch dargestellt ist,

Fig. 2: die o.g. erste Ausführungsform der Erfindung in einem Schnitt gemäß der Linie II-II in Fig. 1,

Fig. 3: die o.g. zweite Ausführungsform der Erfindung in einem Schnitt gemäß der Linie III-III in Fig. 1,

Fig. 4: ein weiteres Ausführungsbeispiel schematisch in einer Seitenansicht mit zugehörigem Schemabild der Flüssigkeitsführung.

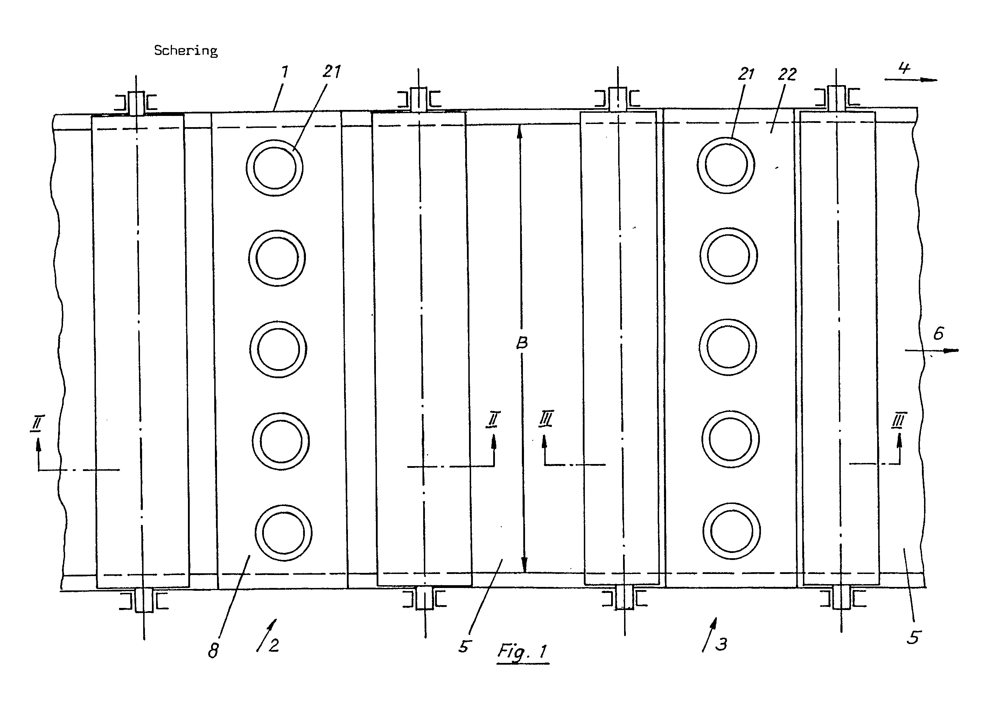

Fig. 1 zeigt in der Draufsicht schematisch einen Teil 1 einer galvanischen Anlage mit mehreren Reinigungs- oder Behandlungsstrecken 2, 3, die in Pfeilrichtung 4 in der gewünschten Anzahl hintereinander angeordnet sind. Das zu reinigende oder zu behandelnde Gut, hier Platten 5, insbesondere Leiterplatten für elektronische Zwecke, wird in Pfeilrichtung 6 transportiert.

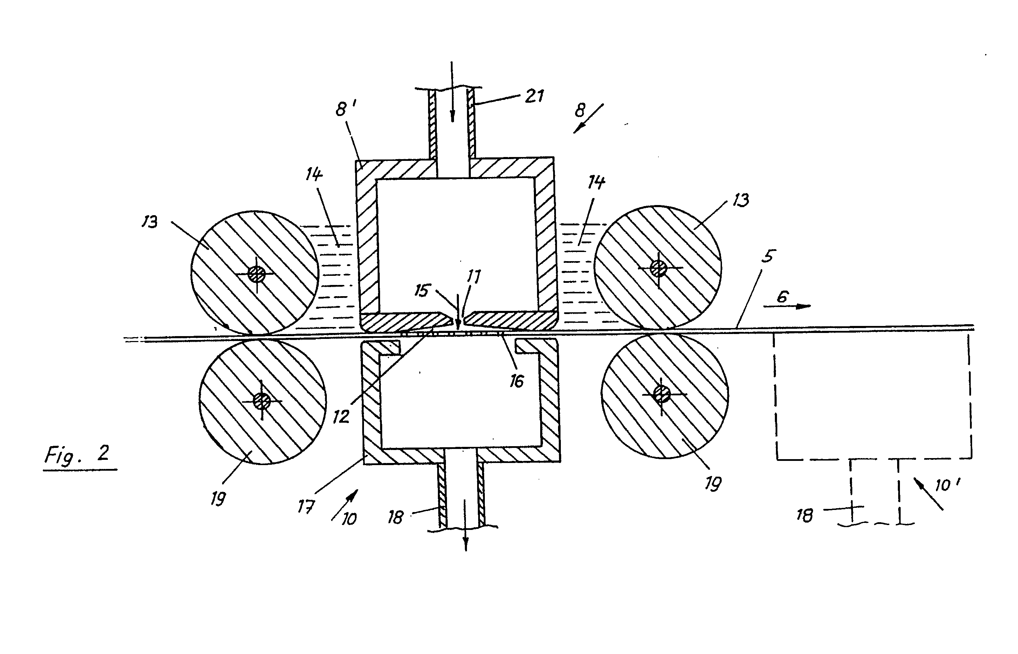

Das Ausführungsbeispiel der Fig. 2 zeigt die o.g. Strecke 2, wobei das Gut 5 von der schmalen Seitenkante her gesehen ist. Es weist Bohrungen 7 auf, die aus Gründen der zeichnerischen Vereinfachung nur im Bereich der Strecke gezeichnet sind. Der Transport des Gutes kann durch in der Zeichnung nicht dargestellte Transportwalzen erfolgen. Die Flüssigkeitszufuhr zum Gut 5 erfolgt mittels einer Schwallstrecke 8 mit Gehäuse 8', welcher die Flüssigkeit über Leitungen 9 zugeleitet wird. Die Länge L der Schwallstrecke ist Fig. 1 zu entnehmen. Sie erstreckt sich über die gesamte Breite des Teiles 1, so daß das Gut 5 über seine Gesamtbreite B gereinigt oder behandelt werden kann. Die Flüssigkeit tritt durch einen Schlitz 11, der sich ebenfalls über die Länge L erstreckt, in den Schwallraum 12. Durch am Eingang und am Ausgang der Schwallstrecke befindliche Quetschwalzen 13 kann ein Flüssigkeitsstau 14 beiderseits der Seitenwände des Gehäuses 8' erreicht werden. Dies verlängert, wie bereits erwähnt, die Strecke, über welche die Behandlungsflüssigkeit auf das Gut einwirken kann. Der Stromschwall gelangt nach Durchsetzung der Bohrungen 16 des Gutes 5 in das Gehäuse 17 der Saugstrecke 10, um dort durch die Leitung 18 abgesaugt zu werden. Das Verhältnis der über die Schwallstrecke 8 zugeführten zu der über die Saugstrecke 10 abgeführten Flüssigkeitsmenge kann zur Erzielung der jeweils besten Wirkung eingestellt werden. Insbesondere kann es von Vorteil sein, pro Zeiteinheit mehr an Flüssigkeit abzusaugen als zuzuführen. In diesem Fall trifft der Flüssigkeitsstrahl durch die Bohrungen 16 nicht direkt auf eine Flüssigkeit auf und der in der Saugstrecke 10 herrschende Unterdruck unterstützt das Durchdringen der Bohrungen 16 durch die Flüssigkeit.

Die sich über die gesamte Länge L erstreckenden Quetschwalzen 13 sind drehbar gelagert, so daß zwischen ihnen und dem anliegenden, in Pfeilrichtung 6 bewegten Gut keine Reibung auftritt. 19 sind Gegendruckwalzen zu den Quetschwalzen 13. Die Walzen 13, 19 können zugleich Transportfunktion haben. Gegebenenfalls könnten auch gesonderte, in der Zeichnung nicht dargestellte Transportwalzen vorgesehen sein, die bevorzugt nicht wie die Quetschwalzen und Gegendruckwalzen durchgehend sind, sondern aus einzelnen scheibenförmigen Walzenstücken bestehen.

In diesem Ausführungsbeispiel liegt die Saugstrecke 10 der Schwallstrecke 8 direkt gegenüber. Sie könnte aber auch in Transportrichtung des Gutes versetzt (gemäß gestrichelter Darstellung 10') vorgesehen sein. Es ist auch möglich, bei einer oberhalb des Gutes vorgesehenen Schwallstrecke 8 gemäß diesem Ausführungsbeispiel auf der Unterseite des Gutes zwei Saugstrecken vorzusehen, nämlich eine gemäß Ziffer 10 direkt der Schwallstrecke 8 gegenüber und eine weitere gemäß 10' im o.g. Sinn versetzt anzuordnen. Welche der vorstehend beschriebenen Varianten in der Praxis verwendet werden, hängt von der Art des Gutes und insbesondere der zu behandelnden oder zu säubernden Bohrungen und auch davon ab, ob es sich um eine Behandlungsstation oder eine Reinigungsstation handelt.

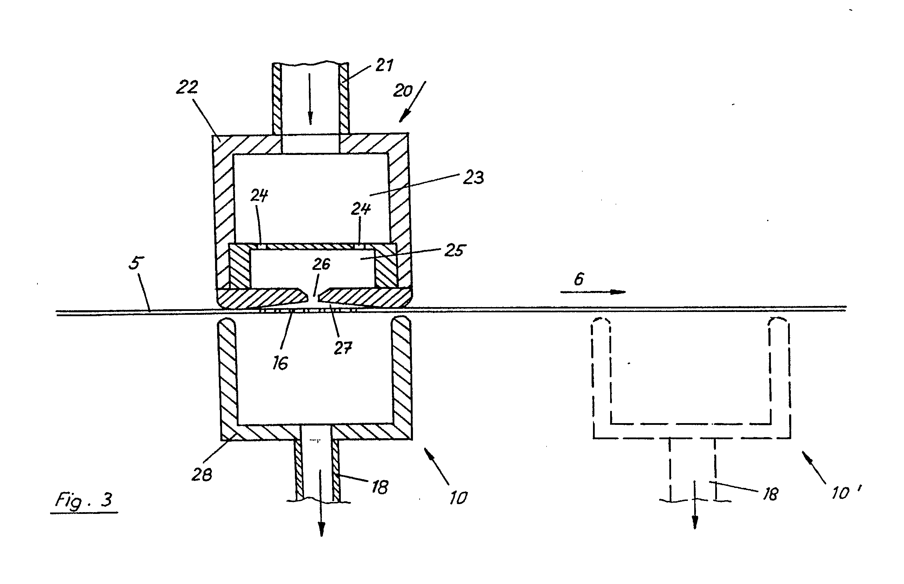

Fig. 3 zeigt im Prinzip die gleiche Anordnung wie Fig. 2, nämlich eine oberhalb des Gutes 5 vorgesehene Schwallstrecke 20, eine direkt gegenüberliegende Saugstrecke 10 und/oder eine in Transportrichtung 6 versetzte und ebenfalls unterhalb des Gutes 5 befindliche Saugstation 10'. Im Unterschied zur Ausführungsform gemäß Fig. 2 wird hier die Flüssigkeit, z.B. reines Wasser, über eine Reihe von Zuführungen 21 größeren Durchmessers im Gehäuse 22 der Schwallstrecke 20 einem Vorraum 23 zugeleitet, der sich praktisch über die gesamte Länge L des Gehäuses 22 der Schwallstrecke erstreckt. Von dort gelangt die Flüssigkeit über zwei oder mehrere Reihen von Bohrungen 24 kleineren Durchmessers (bezogen auf den Durchmesser der Zuführungen 21) in einen Verteilerraum 25. Die Bohrungen 24 sind dabei ebenfalls über die Länge L verteilt hintereinander vorgesehen. Die Anzahl von Bohrungen 24 kleineren Durchmessers wirkt wie eine Lochmaske. Beim Übergang der Flüssigkeit von dem Vorraum 23 in den Verteilerraum 25 erfolgt ein gewisser Druckabfall der Flüssigkeit und gleichzeitig über die Lochmaske eine gleichmäßige Verteilung der Flüssigkeit innerhalb des Verteilerraumes 25 über die gesamte Länge L. Somit tritt aus der schlitzförmigen, sich ebenfalls über die gesamte Länge L erstreckenden Schwallöffnung 26 die Flüssigkeit in einem gleichmäßigen Schwall aus und verteilt sich in den Schwallraum 27, um von dort durch die Bohrungen 16 des Gutes und dann gemäß den Pfeilen 18 nach unten in das Gehäuse 28 der Saugstrecke 10 zu gelangen. Von dort erfolgt die Absaugung über die Leitung 18. Hinsichtlich der Saugstrecke 10 und/oder des Einsatzes der Saugstrecke 10' wird auf die vorstehenden Ausführungen verwiesen. Es können auch (hier nicht dargestellte) Quetschwalzen zur Schaffung eines Flüssigkeitsstaues oder -bettes gemäß Ziffer 14 vorgesehen sein. Die Bohrungen 24 sind zu den Zuführungen 21 in Transportrichtung 6 versetzt, damit die Flüssigkeit nicht in gerader Linie von den Zuführungen 21 durch eine Bohrung 24 auf die schlitzförmige Öffnung 26 treffen soll. Es ist also auch eine entsprechende Versetzung der Bohrungen 24 zur schlitzförmigen Öffnung 26 vorgesehen.

Die Anordnung von Schwallstrecke und Saugstrecke kann auch umgekehrt sein, d.h. die Schwallstrecke, bzw. die Schwallstrecken befinden sich unterhalb der Gutbahn und die Saugstrecke, bzw. Saugstrecken oberhalb der Gutbahn. Dies ist hinsichtlich der Ausführungsbeispiele gemäß der Fig. 2 und 3 nicht noch einmal zeichnerisch gesondert dargestellt.

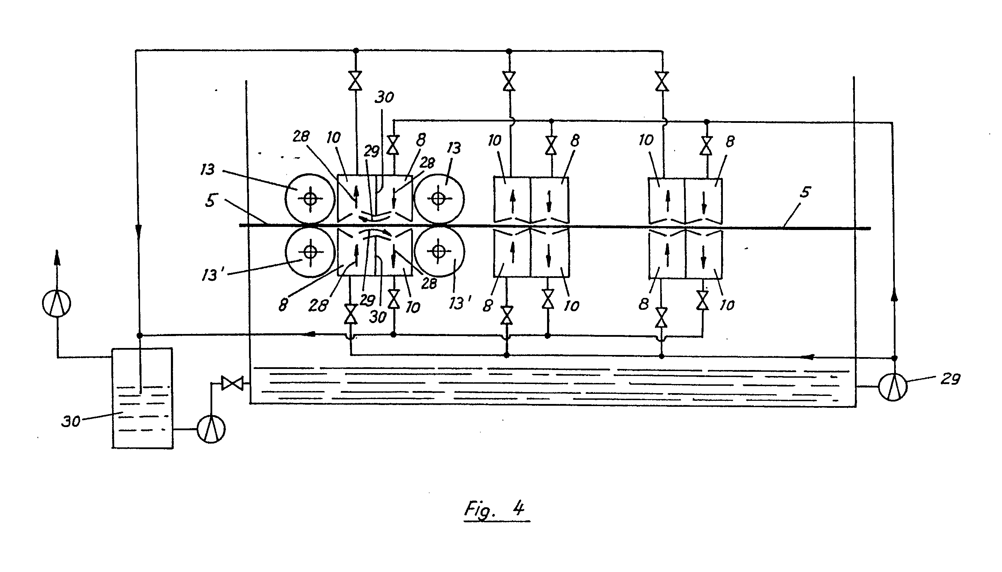

Im Ausführungsbeispiel gemäß Fig. 4 sind je zwei Gruppen, bestehend aus einer Schwallstrecke 8 und einer Saugstrecke 10, nebeneinander vorgesehen, wobei in der einen Gruppe (dies ist gemäß diesem Beispiel die in Transportrichtung das Gut zuerst behandelte Gruppe) sich die Schwallstrecke 8 unterhalb und die Saugstrecke 10 oberhalb der Gutbahn befindet, während die sich daran anschließenden weitere Gruppe so angeordnet ist, daß die Schwallstrecke 8 oberhalb und die Saugstrecke 10 unterhalb des Gutes gelegen ist. Somit wird das zu behandelnde Gut, d.h. dessen Bohrungen nacheinander von unten nach oben und hierauf wieder von oben nach unten durchgespült und somit einer intensiven Reinigung bzw. Behandlung ausgesetzt. Auch hier können Quetschwalzen 13 und entsprechende Gegenwalzen 13' vorgesehen sein, wie es aus Gründen der zeichnerischen Vereinfachung aber nur im ersten Gruppenpaar dargestellt ist. Transportwalzen können ebenfalls vorgesehen sein, sind aber aus Gründen der zeichnerischen Vereinfachung nicht dargestellt; bzw. die Transportfunktion kann auch hier von den Walzen 13, 13' übernommen werden. Dies ist die bevorzugte Ausführungsform der Erfindung.

Fig. 4 zeigt im linken Abschnitt, in dem auch die Quetschwalzen 13 dargestellt sind, daß zusätzlich zu den Schwallströmungen gemäß den senkrecht verlaufenden Pfeilen 28 auch noch von den entsprechenden senkrechten Strömen abgezweigte etwa waagerecht verlaufende Strömungen gemäß dem Pfeil 29 erzielt werden können. Hierzu ist lediglich die mittlere Trennwand 30 zwischen den beiden Gruppen nicht bis auf das Gut 5 hinunterzuführen, sondern es ist dort jeweils ein Zwischenraum für die Strömungen 29 freizulassen. Diese Strömungen 29 spülen Sackbohrungen oder Sacklöscher aus, die von senkrecht verlaufenden Strömungen nicht oder nur sehr unvollkommen gereinigt werden können. Es hängt von den Bemessungen der Strömungsquerschnitte ab, ob man die vertikalen oder die waagerechten Ströme am stärksten macht. Bei dieser Anordnung nach der Erfindung empfiehlt es sich, die Quetschwalzen 13 möglichst dicht an die Gehäuse dieser Gruppen heranzuführen, damit die waagerechten Strömungen nicht zwischen Quetschwalze und Gehäuse der jeweiligen Gruppe nach oben abfließen.

Das mittlere Paar Baugruppen und das in Fig. 4 rechte Paar Baugruppen zeigt die oben bereits erwähnte Ausführung, bei der in der einen Gruppe ein Schwallstrom von unten nach oben und in der benachbarten, dazugehörigen Gruppe ein Schwallstrom von oben nach unten fließt, wobei Querströme nicht vorhanden sind. Auch hier können Quetschwalzen, z.B. in eine Anordnung nach Fig. 2 vorgesehen sein, was aber aus Gründen der zeichnerischen Vereinfachung nicht dargestellt ist.

Das Schaltschema zeigt eine Druckpumpe 29 für die Zufuhr der Flüssigkeit zu den Schwallstrekken 8 und eine Saugvorrichtung oder Pumpe 30 für das Absaugen der Flüssigkeit aus den Saugstrekken.

Eine Reinigungs- oder Behandlungsflüssigkeit kann neben reinem Wasser auch eine Säure, wie eine Schwefelsäure, oder eine Base sein. Bei einer REinigung werden Rückstände auch aus Bohrungen 7 von sehr kleinem Durchmesser, von z.B. 0,1 mm, einwandfrei herausgespült.

Die in Fig. 3 dargestellte Ausführung der Schwallstrecken mit Vorraum 23 und Verteilerraum 25 ist die bevorzugte Ausführungsform der Erfindung, die auch bei den Ausführungen nach Fig. 4 vorgesehen sein kann. Das eingangs erläuterte Prinzip der Erfindung kann aber auch ohne diese Anordnung aus Vorraum und Verteilerraum verwirklicht werden, indem die Behandlungs- oder Reinigungsflüssigkeit der Schwallstrecke unmittelbar gemäß Fig. 2 zugeführt wird. Auch diese Variante gilt für die Ausführungen nach Fig. 4.

In einer Anlage zum chemischen Behandeln und/oder Reinigen von plattenförmigen Gegenständen können in der Transportrichtung 6 des Gutes unterschiedliche Arten von Kombinationen von Schwallstrecken und Saugstrecken vorgesehen sein, wie es jeweils gewünscht ist bzw. den Erfordernissen entspricht; insbesondere ob es sich um eine Behandlung des Gutes mit einer bestimmten Flüssigkeit (z.B. einer Säure) oder um die Reinigung eines Gutes mittels Wasser handelt.

Alle dargestellten und beschriebenen Merkmale, sowie ihre Kombinationen, sind erfindungswesentlich.

**Patentansprüche**

1. Anordnung zur Behandlung und/oder Reinigung von Gut, insbesondere von mit Bohrungen versehenen Leiterplatten, mit Hilfe einer im Schwall herangeführten Flüssigkeit, dadurch gekennzeichnet, daß auf einer Seite des zu reinigenden oder zu behandelnden Gutes (5) eine Schwallstrecke (8, 20) und auf der anderen Seite des Gutes eine Saugstrecke (10, 10') vorgesehen ist.

2. Anordnung nach Anspruch 1,, dadurch gekennzeichnet, daß Schwallstrecken (8, 20) und Saugstrecke (10) einander gegenüberliegen.

3. Anordnung nach Anspruch 1 oder 2, dadurch gekennzeichnet, daß eine Saugstrecke (10') in Transportrichtung (6) des Gutes zur dazugehörigen Schwallstrecke (8, 20) versetzt angeordnet ist.

4. Anordnung nach einem der Ansprüche 1 bis 3, dadurch gekennzeichnet, daß durch Anordnung der Schwallstrecke bzw. mehrerer Schwallstrecken oberhalb und einer Saugstrecke bzw. mehrerer Saugstrecken unterhalb der Bahn des zu behandelnden Gutes.

5. Anordnung nach einem der Ansprüche 1 bis 4, gekennzeichnet durch die Anordnung einer oder mehrerer Schwallstrecken unterhalb und einer oder mehrerer Saugstrecken oberhalb des zu behandelnden Gutes.

6. Anordnung nach einem der Ansprüche 1 bis 5, dadurch gekennzeichnet, daß zwei Gruppen mit je einer Schwallstrecke (8, 20) und einer Saugstrecke (10) in Transportrichtung (6) des Gutes (5) direkt hintereinander angeordnet sind, wobei sich in der einen Gruppe die Schwallstrecke (8, 20) unterhalb und die Saugstrecke (10) oberhalb der Gutbahn und in der anderen Gruppe die Schwallstrecke oberhalb und die Saugstrecke unterhalb der Gutbahn befinden.

7. Anordnung nach einem der Ansprüche 1 bis 6, dadurch gekennzeichnet, daß in Transportrichtung (6) des Gutes (5) betrachtet am Eingang und Ausgang jeder Schwallstrecke ein auf dem Gut aufliegendes Staumittel (13) vorgesehen ist derart, daß zwischen den beiden Staumitteln und der Schwallstrecke ein aufgestautes Flüssigkeitsbett (14) entsteht.

8. Anordnung nach Anspruch 7, dadurch gekennzeichnet, daß als Staumittel Quetschwalzen (13) vorgesehen sind.

9. Anordnung nach einem der Ansprüche 6 bis 8, dadurch gekennzeichnet, daß die Trennwand (30) zwischen direkt hintereinander angeordneten Gruppen, die je aus einer Saugstrecke (10) und einer Schwallstrecke (8) bestehen, in einem solchen Abstand von dem durch die Gruppen hindurchgeführten plattenförmigen Gut (5) endet, daß - zusätzlich zu den vertikal innerhalb jeder dieser beiden Gruppen verlaufenden Schwallströmen (28) - 1 Quer-Schwallstrom (29) bzw. Quer-Schwallströme (29) zwischen den oberhalb und/oder zwischen den unterhalb der Gutbahn befindlichen Strecken (10, 8; 8, 10) verlaufen kann, bzw. können.

10. Anordnung nach Anspruch 9, dadurch gekennzeichnet, daß die Staumittel (13) dicht an den Außenflächen der beiden Gruppen anliegen.

11. Anordnung nach einem der Ansprüche 1 bis 10, dadurch gekennzeichnet, daß die Schwallstrecke einen Vorraum (23) mit Zugangsöffnungen oder Zuführungen (21) größeren Durchmessers, eine sich in Strömungsrichtung der Flüssigkeit daran anschließende Lochmaske mit Bohrungen (24) kleineren Durchmessers und einen sich in Strömungsrichtung daran anschließenden Verteilerraum (25) aufweist, der in Strömungsrichtung der Flüssigkeit einen Austrittsschlitz (26) aufweist, der zu einem Schwallraum (27) führt, wobei die Zuführungsreihe (21), der Vorraum (23), die Bohrungen (24), der Verteilerraum (25), der Austrittsschlitz (26) und der Schwallraum (27) sich im wesentlichen über die gesamte Länge (L) des Gehäuses (22) der Schwallstrecke erstrecken.

12. Anordnung nach Anspruch 11, dadurch gekennzeichnet, daß die Bohrungen (24) kleineren Durchmessers in Transportrichtung (6) des Gutes sowohl zu den Zuführungen (21) größeren Durchmessers, als auch zum Austrittsschlitz (26) versetzt sind.

13. Anordnung nach einem der Ansprüche 1 bis 10, dadurch gekennzeichnet, daß, insbesondere bei kürzeren Schwallstrecken, die Anzahl der Zuführungen (21), sowie die Größe deren gesamten Querschnittsflächen gegenüber der Querschnittsfläche des Austrittsschlitzes (26) so groß gewählt ist, daß der überwiegende Druckabfall erst am Austrittsschlitz (26) eintritt, so daß zur Erzielung einer ausreichenden Gleichmäßigkeit der Verteilung der Flüssigkeit im Austrittsschlitz (26) auf die Lochmaske mit den Bohrungen (24) und den Verteilerraum (25) verzichtet werden kann.

14. Verfahren zur Behandlung und/oder Reinigung von Gut, insbesondere von mit Bohrungen versehenen Leiterplatten mit Hilfe einer im Schwall herangeführten Flüssigkeit und der Benutzung einer Anordnung nach einem der Ansprüche 1 bis 13, dadurch gekennzeichnet, daß das Verhältnis der über die jeweilige Schwallstrecke (8) zugeführten Flüssigkeitsmenge zu der über die jeweilige Saugstrecke (10) abgeführten Flüssigkeitsmenge zur Erzielung einer bestimmten Wirkung einstellbar ist, insbesondere daß pro Zeiteinheit mehr an Flüssigkeit in der Saugstrecke abgesaugt als in der Schwallstrecke zugeführt wird.

Schering

EP 0 456 870 A1

Fig. 1

Fig. 2

Fig. 3

Fig. 4

EP 0 456 870 A1

**Europäisches Patentamt**

# EUROPÄISCHER RECHERCHENBERICHT

Nummer der Anmeldung

**EP 90 10 9413**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | EP-A-0 329 807   (SCHMID)<br>* Figuren 1-3; Spalte 4, Zeile 23 - Spalte 5, Zeile 48 *<br>— — — | 1-5,7,8, 14 | H 05 K 3/26<br>B 08 B 3/02 |
| A | GB-A-2 197 581   (TELEDYNE)<br>* Figuren 2,3; Seite 5, Zeile 34 - Seite 9, Zeile 29 *<br>— — — | 1-3,7-11, 13,14 | |
| A | DE-A-3 419 141   (SCHMID)<br>* Figur 1; Seite 12, Zeile 20 - Seite 13, Zeile 17 *<br>— — — | 1,2,4,7,8, 14 | |
| A,D | EP-A-0 037 483   (SIEMENS)<br>* Figur 1; Ansprüche 1-3 *<br>— — — | 1,7-9 | |
| A,D | EP-A-0 212 253   (SCHERING)<br>* ganzes Dokument *<br>— — — — — | 1,14 | |

| | | | RECHERCHIERTE SACHGEBIETE (Int. Cl.5) |
|---|---|---|---|
| | | | H 05 K 3/00<br>B 08 B 3/00 |

Der vorliegende Recherchenbericht wurde für alle Patentansprüche erstellt

| Recherchenort | Abschlußdatum der Recherche | Prüfer |
|---|---|---|
| Berlin | 15 Januar 91 | HAHN G |